# EUROPEAN PATENT APPLICATION

(11) **EP 3 315 232 A1**
(43) Date of publication of application: **02.05.2018**
(21) Application number: 16814432.7
(22) Date of filing: 23.06.2016
(51) Int. Cl.: B23B 27/14, C23C 16/30, C23C 16/36, C23C 16/40

(54) **COATED SURFACE CUTTING TOOL**

(30) Priority: 26.06.2015 JP 2015129102; 14.06.2016 JP 2016117818
(71) Applicant: Mitsubishi Materials Corporation, Chiyoda-ku Tokyo 100-8117 (JP)
(72) Inventor: OKUDE, Masaki, Naka-shi Ibaraki 311-0102 (JP); YAMAGUCHI, Kenji, Naka-shi Ibaraki 311-0102 (JP)
(74) Representative: Gille Hrabal
(86) International application number: PCT/JP2016/068628
(87) International publication number: WO 2016/208663

(57) **Abstract**

To provide a surface-coated cutting tool that exhibits excellent peeling resistance and chipping resistance under heavy cutting conditions with high-speed, large depth of cut and high feed rate in which a high load is exerted on a cutting edge.

In a surface-coated cutting tool including a tool body that is made of a tungsten carbide-based cemented carbide or a titanium carbonitride-based cermet and a hard coating layer that includes a lower layer and an upper layer and formed on a surface of the tool body, the lower layer is composed of a Ti compound layer including at least a TiCN layer; the upper layer includes an Al₂O₃ layer having an α-type crystal structure; regarding Al₂O₃ crystal grains of the upper layer, in a case where a coincidence grain boundary distribution graph is measured, sulfur is segregated in a grain boundary of ∑31 or more and a grain boundary length thereof is 20% to 50% relative to the whole grain boundary length in the constituent atom sharing lattice point form of ∑3 or more; and absolute values of residual stress values of a flank face and a rake face including at least a cutting edge ridge line part of the upper layer are 100 MPa or less.

## Description

### Technical Field

The present invention relates to a surface-coated cutting tool (hereinafter, referred to as a coated tool) that has a hard coating layer exhibiting excellent peeling resistance and chipping resistance and exhibits excellent cutting performance over a long period of time even in a case where cutting of various steels, cast irons, and the like is performed at a high speed under heavy cutting conditions with high feed rate and large depth of cut in which a high load is exerted on a cutting edge.

### Background Art

Coated tools have been generally known in which a hard coating layer composed of (a) and (b) is deposited on a surface of a body made of a tungsten carbide (hereinafter, expressed by WC)-based cemented carbide or a titanium carbonitride (hereinafter, expressed by TiCN)-based cermet (hereinafter, these will be collectively referred to as a tool body).
(a) A Ti compound layer as a lower layer including one or two or more of a Ti carbide (hereinafter, expressed by TiC) layer, a Ti nitride (hereinafter, similarly expressed by TiN) layer, a Ti carbonitride (hereinafter, expressed by TiCN) layer, a Ti oxycarbide (hereinafter, expressed by TiCO) layer, and a Ti oxycarbonitride (hereinafter, expressed by TiCNO) layer.
(b) An aluminum oxide layer (hereinafter, expressed by an Al₂O₃ layer) as an upper layer having an α-type crystal structure in a chemically vapor-deposited state.

However, the above-described conventional coated tools exhibit excellent wear resistance in, for example, continuous cutting of various steels, cast irons, and the like, but in a case where the coated tool is used in high-speed intermittent cutting, peeling and/or chipping of the coating layer easily occurs, and there is a problem in that the tool life is reduced.

Therefore, various coated tools having improved upper and lower layers have been proposed in order to suppress peeling and/or chipping of the coating layer.

For example, PTL 1 discloses a coated tool obtained by depositing a hard coating layer composed of (a) and (b) on a surface of a tool body made of a WC-based cemented carbide or a TiCN-based cermet, and the coated tool is known to exhibit excellent chipping resistance in high-speed intermittent cutting.
(a) A Ti compound layer as a lower layer composed of one or two or more of a Ti carbide layer, a Ti nitride layer, a Ti carbonitride layer, a Ti oxycarbide layer, and a Ti oxycarbonitride layer and having a total average layer thickness of 3 to 20 µm.
(b) An aluminum oxide layer as an upper layer with an average layer thickness of 1 to 15 µm having an α-type crystal structure in a chemically vapor-deposited state. Using a field-emission-type scanning electron microscope, crystal grains having a hexagonal crystal lattice present within a measurement range of a polished surface are individually irradiated with electron beams to measure inclined angles between normal lines of the (0001) plane and the (10-10) plane, that are crystal planes of the crystal grains, and a normal line of the polished surface; the crystal grains of this case have a corundum hexagonal crystal structure in which constituent atoms including Al and oxygen are present at lattice points, respectively; the distribution of coincidence grain boundary formed of lattice points (constituent atom sharing lattice points) where the respective constituent atoms share one constituent atom between the crystal grains at an interface between the mutually adjacent crystal grains is calculated on the basis of the resulting measured inclined angles; and in a case where the coincidence grain boundary formed of a constituent atom sharing lattice point form in which N (here, N is any even number equal to or more than 2 in the corundum hexagonal crystal structure, but in a case where the upper limit of N is 28 from the viewpoint of distribution frequency, even numbers 4, 8, 14, 24, and 26 do not exist) lattice points that do not share any constituent atoms between the constituent atom sharing lattice points are present is expressed by ∑N+1, a maximum peak is present in ∑3 in a constituent atom sharing lattice point distribution graph showing distribution ratios of individuals of ∑N+1 in the whole of ∑N+1, and a distribution ratio of ∑3 in the whole of ∑N+1 is 60% to 80% .

PTL 2 proposes that in a coated tool in which a lower layer and an upper layer are coated on a surface of a tool body, a crack filling heating transformation α-type aluminum oxide layer satisfying the following (a) to (c) is used as the upper layer to improve chipping resistance in high-speed intermittent cutting.
(a) A heating transformation α-type aluminum oxide layer that is obtained by performing a heating treatment on an aluminum oxide layer having a κ- or θ-type crystal structure in a chemically deposited state for transforming the crystal structure into an α-type crystal structure, and has a structure distributed dendritically discontinuous cracks as cracks generated by heating transformation in the layer in cross-section observation and an average layer thickness of 1 to 15 µm is used as a layer body.
(b) By performing a shot blast treatment on a surface of the layer body, a distribution form of the dendritically discontinuous cracks existing in the layer body is changed to a state in which net-like continuous cracks are distributed in the layer in cross-section observation.
(c) The net-like continuous cracks are filled with titanium nitride of 0.5 to 5 mass% of a total amount with the layer body by chemical vapor deposition.

PTL 3 proposes a coated tool in which a hard coating layer including a Ti compound layer as a lower layer and an α-type Al₂O₃ layer as an upper layer is deposited, in which 30% to 70% of Al₂O₃ crystal grains immediately above the lower layer is constituted of (11-20)-oriented Al₂O₃ crystal grains, at least 45% of all Al₂O₃ crystal grains of the upper layer is constituted of (0001)-oriented Al₂O₃ crystal grains, an outermost surface layer of the lower layer is preferably constituted of an oxygen-containing TiCN layer containing 0.5 to 3 atom% of oxygen only in a depth region with a depth of 500 nm, and a value of a ratio between the number of oxygen-containing TiCN crystal grains of the outermost surface layer of the lower layer and the number of Al₂O₃ crystal grains at an interface between the lower layer and the upper layer is 0.01 to 0.5, therefore peeling resistance and chipping resistance in high-speed heavy cutting or high-speed intermittent cutting are improved.

### Citation List

### Patent Literature

[PTL 1] JP-A-2006-198735
[PTL 2] Japanese Patent No. 4389593
[PTL 3] JP-A-2013-63504

### Summary of Invention

### Technical Problem

In recent years, performance of cutting devices has been significantly improved, and there is strong demand for power saving, energy saving, and cost reduction in cutting. In addition, cutting speed has been further increased, and there is a tendency that a high load is exerted on a cutting edge in heavy cutting, intermittent cutting, and the like such as large depth of cut and high feed rate. There are no problems in a case where the above-described conventional coated tools are used in continuous cutting of steel, cast irons, and the like under the normal conditions. However, in a case where the conventional coated tools are used under heavy cutting conditions with high-speed, large depth of cut and high feed rate, peeling of the hard coating layer is easily occurred, and thus the end of the tool life is reached in a relatively short period of time.

### Solution to Problem

Accordingly, from the above-described viewpoint, the inventors have performed intensive studies on the structure of a hard coating layer in which peeling and chipping does not occur even under heavy cutting conditions with high-speed, large depth of cut and high feed rate in which a high load is exerted on a cutting edge and a tool body plastically deforms easily, and found that the occurrence of peeling and/or chipping of the hard coating layer is suppressed under heavy cutting conditions with high-speed, large depth of cut and high feed rate by forming, on a crystal grain boundary of Al₂O₃ crystal grains, cracks having a predetermined length ratio with respect to the whole grain boundary length in an Al₂O₃ layer constituting the upper layer of the hard coating layer.

The invention is based on the above-described knowledge.
(1) A surface-coated cutting tool including a tool body that is made of a tungsten carbide-based cemented carbide or a titanium carbonitride-based cermet, and a hard coating layer that includes a lower layer and an upper layer and is formed on a surface of the tool body, in which (a) the lower layer has a total average layer thickness of 3 to 20 µm and includes two or more of a TiC layer, a TiN layer, a TiCN layer, a TiCO layer, and a TiCNO layer, and at least one of the layers is a Ti compound layer including a TiCN layer, (b) the upper layer has an average layer thickness of 2 to 15 µm and includes an Al₂O₃ layer having an α-type crystal structure, and (c) regarding Al₂O₃ crystal grains of the upper layer, in a case where a polished cross-section is subjected to observation and elemental analysis using high angle annular dark field scanning transmission electron microscopy and observation using a field-emission-type scanning electron microscope and an electron beam backward scattering diffraction device, angles between each of normal lines of crystal lattice planes formed of corundum hexagonal crystal lattices and a normal line of the polished cross-section are measured, and from results of the measurement, a crystal orientation relationship between the mutually adjacent crystal lattices is calculated and the distribution of lattice points (constituent atom sharing lattice points) where respective constituent atoms constituting a crystal lattice interface share one constituent atom between the crystal lattices is calculated; in a case where a constituent atom sharing lattice point form in which N lattice points that do not share any constituent atoms between the constituent atom sharing lattice points are present is expressed by ∑N+1, distribution ratios of individuals of ∑N+1 are calculated; and in a coincidence grain boundary distribution graph showing ratios of respective coincidence grain boundary lengths formed of the constituent atom sharing lattice points in the whole coincidence grain boundary length, sulfur is segregated in a grain boundary in the constituent atom sharing lattice point form of ∑31 or more, and a grain boundary length thereof is 20% to 50% relative to the whole grain boundary length in the constituent atom sharing lattice point form of ∑3 or more.
(2) The surface-coated cutting tool according to (1), in which an outermost surface layer of the lower layer (a) includes a TiCN layer having a layer thickness of at least 500 nm or more and contains oxygen only in a depth region with a depth of up to 500 nm from an interface between the TiCN layer and the upper layer, except for oxygen as inevitable impurities, and an average content of the oxygen contained in the depth region is 1 to 3 atom% of a total content of Ti, C, N, and O contained in the depth region.
(3) The surface-coated cutting tool according to (1) or (2), in which regarding the Al₂O₃ crystal grains of the upper layer, in a case where, using a field-emission-type scanning electron microscope and an electron beam backward scattering diffraction device, crystal grains having a corundum hexagonal crystal lattice that are present within a measurement range of a polished cross-section are individually irradiated with electron beams to measure inclined angles between normal lines of (0001) planes that are crystal planes of the crystal grains and a normal line of the surface of the tool body, and the measured inclined angles of 0 to 45 degrees among the measured inclined angles are divided every pitch of 0.25 degrees and expressed by an inclined angle frequency distribution made by totalizing the frequencies present of the respective divisions, a maximum peak is present in an inclined angle division of 0 to 10 degrees, and a total of frequencies present in the range of 0 to 10 degrees is 50% or greater of the entire frequencies in an inclined angle frequency distribution graph.
(4) The surface-coated cutting tool according to any one of (1) to (3), in which absolute values of residual stresses of a flank face and a rake face of the surface-coated cutting tool are 100 MPa or less."

The coated tool according to the invention will be described in detail.

### (a) Lower Layer:

Basically, a Ti compound layer (for example, TiC layer, TiN layer, TiCN layer, TiCO layer, and TiCNO layer) constituting a lower layer is present as a layer below an Al₂O₃ layer, and imparts high-temperature strength to a hard coating layer due to its excellent high-temperature strength. In addition, the Ti compound layer tightly adheres to both of a surface of a tool body and an upper layer including an Al₂O₃ layer, and acts to maintain adhesion of the hard coating layer to the tool body. However, in a case where the total average layer thickness of the Ti compound layer is less than 3 µm, the above-described action cannot be sufficiently exhibited. In a case where the total average layer thickness of the Ti compound layer is greater than 20 µm, thermal plastic deformation easily occurs particularly during high-speed heavy cutting or high-speed intermittent cutting accompanied by generation of high-temperature heat, and uneven wear is caused. Due to the above-described reasons, the total average layer thickness of the Ti compound layer is set to 3 to 20 µm.

### (b) Outermost Surface Layer of Lower Layer:

In the invention, an outermost surface layer of the lower layer is formed, for example, as follows.

That is, first, various Ti compound layers including one or two or more of a TiC layer, a TiN layer, a TiCN layer, a TiCO layer, and a TiCNO layer are deposited (only a TiCN layer may be deposited) using a normal chemical vapor deposition device. Then, as an outermost surface layer of the lower layer, a TiCN layer containing oxygen (hereinafter, referred to as oxygen-containing TiCN) is formed by performing chemical vapor deposition under the following conditions using the same normal chemical vapor deposition device.
Composition of Reaction Gas (vol%): 2% to 10% of TiCl₄, 0.5% to 1.0% of CH₃CN, 25% to 60% of N₂, H₂ as balance
Reaction Atmosphere Temperature: 750°C to 930°C
Reaction Atmosphere Pressure: 5 to 15 kPa

In this case, during 5 minutes to 30 minutes before termination of the vapor deposition time required for obtaining a predetermined layer thickness, a CO gas is added in an amount of 1 to 5 vol% with respect to the entire amount of the reaction gas to perform the chemical vapor deposition. Accordingly, an oxygen-containing TiCN layer in which only in a depth region with a depth of up to 500 nm in a layer thickness direction, an average content of the oxygen is 1 to 3 atom% of a total content of Ti, C, N, and 0 contained in the depth region is deposited. In a depth region deeper than 500 nm in the outermost surface layer of the lower layer, oxygen is permitted to be contained in an amount of less than 0.5 atom% as inevitable impurities. Therefore, the expression "containing no oxygen" means that the content of oxygen is less than 0.5 atom% in a strict sense.

The outermost surface layer of the lower layer composed of the oxygen-containing TiCN layer is formed with a layer thickness of at least 500 nm or more in order to form, for example, preferable Al₂O₃ crystal grains thereon (see the following (c)), and only in a depth region with a depth of up to 500 nm in the layer thickness direction from the interface between the oxygen-containing TiCN layer and the upper layer, oxygen is contained in an amount of 1 to 3 atom% of a total content of Ti, C, N, and 0 contained in the depth region, such that the oxygen is contained only in the depth region with a depth of up to 500 nm.

Here, the reason why the depth region of the oxygen-containing TiCN layer is limited as described above is that in a case where 0.5 atom% or greater of oxygen is contained in a region deeper than 500 nm, the structure form of the outermost surface of TiCN easily changes from a columnar structure to a granular structure, and a desired constituent atom sharing lattice point form of the Al₂O₃ crystal grains immediately above the outermost surface layer of the lower layer cannot be obtained.

In a case where an average oxygen content in the depth region with a depth of up to 500 nm is less than 1 atom%, it is impossible to desire an improvement in the adhesion strength between the upper layer and the lower layer of TiCN. In addition, it is impossible to sufficiently satisfy the formation of the coincidence grain boundary of the Al₂O₃ crystal grains immediately above the outermost surface layer of the lower layer. In a case where the average oxygen content in the depth region is greater than 3 atom%, and in a case where in the upper layer Al₂O₃ immediately above the interface, inclined angles formed by normal lines of the (0001) planes that are crystal planes of the crystal grains are measured and expressed by an inclined angle frequency distribution made by totalizing the frequencies present within the respective divisions, a total of the frequencies present in the above range of 0 to 10 degrees is less than 50% of the entire frequencies in the inclined angle frequency distribution graph, and the high-temperature strength of the upper layer is reduced.

Here, the average oxygen content is the content of oxygen (O), expressed by atom% (= O/(Ti+C+N+O)x100), in a total content of titanium (Ti), carbon (C), nitrogen (N), and oxygen (O) in the depth region with a depth of up to 500 nm in the layer thickness direction of the TiCN layer from the interface between the TiCN layer constituting the outermost surface layer of the lower layer and the upper layer.

### (c) Al₂O₃ Crystal Grains of Upper Layer:

After the oxygen-containing TiCN layer of (b) is deposited as the outermost surface layer of the lower layer, an Al₂O₃ layer as the upper layer is formed, for example, under the following conditions.

That is, a surface of the oxygen-containing TiCN layer formed in (b) is treated under the following conditions.

### <Al₂O₃ Initial Growth>

Composition of Reaction Gas (vol%): 3% to 5% of CO, 3% to 5% of CO₂, H₂ as balance
Atmosphere Temperature: 850°C to 950°C
Atmosphere Pressure: 5 to 15 kPa
Treatment Time: 20 to 60 min

Then, vapor deposition is performed under the following conditions.
Composition of Reaction Gas (vol%): 0.5% to 3% of AlCl₃, 1% to 5% of CO₂, 0.3% to 1.0% of HCl, H₂ as balance
Atmosphere Temperature: 850°C to 950°C
Atmosphere Pressure: 5 to 15 kPa
Treatment Time: 20 to 90 min

### <Formation of Al₂O₃ Upper Layer>

Composition of Reaction Gas (vol%): 0.5% to 5.0% of AlCl₃, 2% to 10% of CO₂, 0.5% to 2.0% of HCl, 0.5% to 1.5% of H₂S, H₂ as balance
Reaction Atmosphere Temperature: 850°C to 950°C
Reaction Atmosphere Pressure: 5 to 15 kPa
Treatment Time: (until target upper layer thickness is obtained)

By depositing under the above conditions, an upper layer including Al₂O₃ crystal grains having a predetermined constituent atom sharing lattice point form is formed.

In a case where the layer thickness of the entire upper layer is less than 2 µm, excellent high-temperature strength and high-temperature hardness cannot be exhibited over a long period of use, and in a case where the layer thickness is greater than 15 µm, chipping easily occurs. Accordingly, the layer thickness of the upper layer is set to 2 to 15 µm.

Regarding the Al₂O₃ crystal grains having an α-type crystal structure that constitute the upper layer, a polished cross-section of the upper layer is subjected to observation and elemental analysis using high angle annular dark field scanning transmission electron microscopy (High Angle Annular Dark Field Scanning transmission electron microscope: hereinafter, referred to as "HAADF-STEM"), and observation using a field-emission-type scanning electron microscope and an electron beam backward scattering diffraction device to analyze the constituent atom sharing lattice point form in detail, and it is found that in a constituent atom sharing lattice point distribution graph, sulfur atoms rarely exist in a grain boundary in the constituent atom sharing lattice point form of ∑3 to ∑29, sulfur atoms are segregated in a grain boundary in the constituent atom sharing lattice point form of ∑31 or more, and the grain boundary length in the constituent atom sharing lattice point form in which sulfur atoms are segregated is 20% to 50% relative to the whole grain boundary length in the constituent atom sharing lattice point form of ∑3 or more.

The constituent atom sharing lattice point form of the upper layer can be measured according to the following procedures.

First, a longitudinal section of the upper layer of the coated tool is treated to be a polished surface.

Next, using a field-emission-type scanning electron microscope and an electron beam backward scattering diffraction device, crystal grains having a corundum hexagonal crystal lattice present within a measurement range of the polished cross-section are individually irradiated with electron beams to measure angles of orientations of normal lines of crystal lattice planes.

From the results of the measurement, a crystal orientation relationship between the mutually adjacent crystal lattices is calculated and the distribution of lattice points (referred to as "constituent atom sharing lattice points") where the respective constituent atoms constituting a crystal lattice interface share one constituent atom between the crystal lattices is calculated.

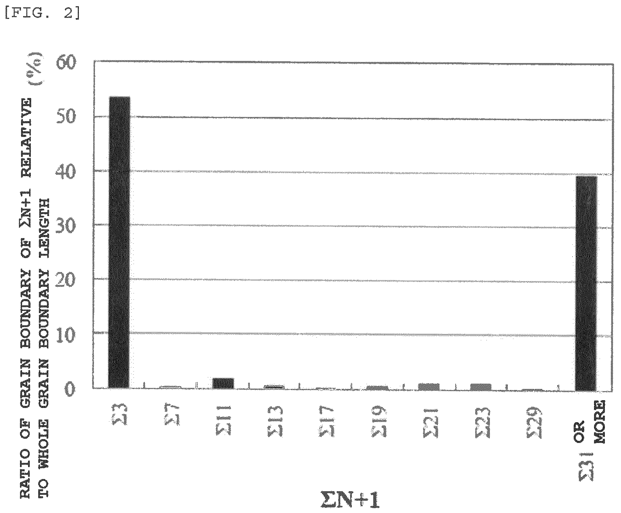

In a case where the constituent atom sharing lattice point form in which N (here, N is any even number equal to or more than 2 in the crystal structure of the corundum hexagonal crystal lattice, but even numbers 4, 8, 14, 24, and 26 do not exist) lattice points that do not share any constituent atoms between the constituent atom sharing lattice points are present is expressed by ∑N+1, distribution ratios of individuals of ∑N+1 are calculated, and a coincidence grain boundary distribution graph (see FIG. 2) showing the distribution ratios of individuals of ∑N+1 in a total distribution ratio of the whole coincidence grain boundary length of ∑3 or more is made. Accordingly, the distribution ratios of ∑3 to ∑29 and the distribution ratio of ∑31 or more can be obtained.

As a method of calculating the distribution ratio of ∑31 or more, coincidence grain boundary lengths of ∑3, ∑7, ∑11, ∑17, ∑19, ∑21, ∑23, and ∑29 are calculated from the obtained measurement results, and a value obtained by subtracting the sum of the coincidence grain boundary lengths from the whole coincidence grain boundary length is used and obtained as a distribution ratio of ∑31 or more.

The reason why the coincidence grain boundary of ∑29 or less is distinguished from the coincidence grain boundary of ∑31 or more is that it has been reported that in view of distribution frequency, the coincidence grain boundary of α-Al₂O₃ is a coincidence grain boundary in which a main grain boundary is from ∑3 to ∑29 with the upper limit of N set to 28 as shown in the article of H. Grimmer, etc. (Philosophical Magazine A, 1990, Vol. 61, No. 3,493-509). Accordingly, in the invention, in a case of ∑31 or more, distribution ratios are not calculated for each N and grouped together as ∑31 or more. The coincidence grain boundary of each of ∑3, ∑7, ∑11, ∑17, ∑19, ∑21, ∑23, and ∑29 was identified using a value of an angle formed between crystal grains constituting the coincidence grain boundary as shown in the above-described article. In addition, from the coincidence grain boundary of ∑N+1 satisfying the constituent atom sharing lattice point form in which N lattice points that do not share any constituent atoms between the constituent atom sharing lattice points are present between the adjacent crystal lattices, a criterion of a permissible error Δθ of the value of the angle formed between the crystal grains was calculated and Δθ=5° was estimated.

In addition, the α-type Al₂O₃ crystal grains having a corundum hexagonal crystal lattice that constitute the upper layer are subjected to elemental analysis by an energy dispersive-type X-ray analysis method using high angle annular dark field scanning transmission electron microscopy (HAADF-STEM) in the measurement range of the polished cross-section in which the constituent atom sharing lattice point form has been observed. In a case where the element distribution obtained from the analysis is compared with the distribution of the crystal grain boundaries determined by the above-described coincidence grain boundary distribution measurement method, sulfur is segregated in a coincidence grain boundary of ∑31 or more, and when its grain boundary length is 20% to 50% relative to the whole grain boundary length of ∑3 or more, particularly excellent peeling resistance is exhibited.

In a case where grain boundaries having such a bonding state are formed in the Al₂O₃ crystal grains, these act as fine break-starting points distributed widely in the hard film, and thus serious peeling and/or chipping of the Al₂O₃ layer can be suppressed even under cutting conditions such as high-speed heavy cutting in which a high load is exerted on a cutting edge.

In a case where the length of the grain boundary in the constituent atom sharing lattice point form of ∑31 or more in which sulfur is segregated is less than 20% relative to the whole grain boundary length in the constituent atom sharing lattice point form of ∑3 or more, the above-described desired effect in peeling resistance or chipping resistance is reduced, and in a case where the length of the grain boundary in the constituent atom sharing lattice point form of ∑31 or more is greater than 50%, the Al₂O₃ layer as the upper layer embrittles.

Accordingly, the grain boundary length in the constituent atom sharing lattice point form in which sulfur atoms are segregated is set to 20% to 50% relative to the whole grain boundary length in the constituent atom sharing lattice point form of ∑3 or more.

In the coated tool according to the invention, after the Al₂O₃ layer as an upper layer is formed by the vapor deposition method, a flank face and a rake face including at least a cutting edge ridge line part of the upper layer are performed, for example, a polishing treatment using a wet blast that sprays a polishing liquid as a spray polishing agent in which fine Al₂O₃ grains are blended in an amount of 15 to 60 mass% of a total amount with water, such that the absolute values of residual stresses of the flank face and the rake face are 100 MPa or less.

Regarding the Al₂O₃ crystal grains of the upper layer according to the invention, in a case where the frequency ratio of (0001)-oriented Al₂O₃ crystal grains is large, the high-temperature hardness and the high-temperature strength of the upper layer are maintained. Accordingly, in the invention, a maximum peak is present in an inclined angle division of 0 to 10 degrees, and the frequency ratio of the (0001)-oriented Al₂O₃ crystal grains of the upper layer is set to 50% or greater.

To obtain the frequency ratio of the (0001)-oriented Al₂O₃ crystal grains, crystal grains having a corundum hexagonal crystal lattice present within a measurement range of a polished cross-section of the upper layer are individually irradiated with electron beams using a field-emission-type scanning electron microscope to obtain data related to orientation of the Al₂O₃ crystal grains. Based on this data, inclined angles between normal lines of the (0001) planes that are crystal planes of the crystal grains and a normal line of the surface of the tool body are measured, and the above frequency ratio of the (0001)-oriented Al₂O₃ crystal grains can be obtained as a ratio of frequencies of crystal grains having an inclined angle of 0 to 10 degrees ((0001)-oriented Al₂O₃ crystal grains) to the entire frequencies.

### Advantageous Effects of Invention

According to the invention, a hard coating layer has a lower layer formed on a surface of a tool body and an upper layer formed on the lower layer, and has a unique configuration in which (a) the lower layer includes two or more Ti compound layers among TiC, TiN, TiCN, TiCO, and TiCNO, and an average oxygen content in a surface layer part (depth region with a depth of up to 500 nm in a layer thickness direction) of a TiCN layer that is an outermost surface layer of the lower layer is 1 to 3 atom%, and (b) the upper layer includes an Al₂O₃ layer having an α-type crystal structure in a chemically vapor-deposited state, a grain boundary of Al₂O₃ grains of the upper layer in a constituent atom sharing lattice point form of ∑31 or more is segregated with sulfur atoms, its grain boundary length is 20% to 50% relative to the whole grain boundary length, a maximum peak is present in an inclined angle division of 0 to 10 degrees in an inclined angle frequency distribution graph obtained regarding inclined angles between normal lines of the (0001) planes of the Al₂O₃ grains of the upper layer and a normal line direction of the surface of the tool body, a frequency ratio is 50% or greater, and absolute values of residual stresses of a flank face and a rake face including at least a cutting edge ridge line part of the upper layer are 100 MPa or less.

Therefore, even in a case where cutting of various steels, cast irons, and the like is performed under heavy cutting conditions with high-speed, large depth of cut and high feed rate in which a high load is exerted on a cutting edge and the tool body plastically deforms easily, peeling and/or chipping of the hard coating layer does not occur, and thus excellent cutting performance is exhibited in use for a long period of time.

### Brief Description of Drawings

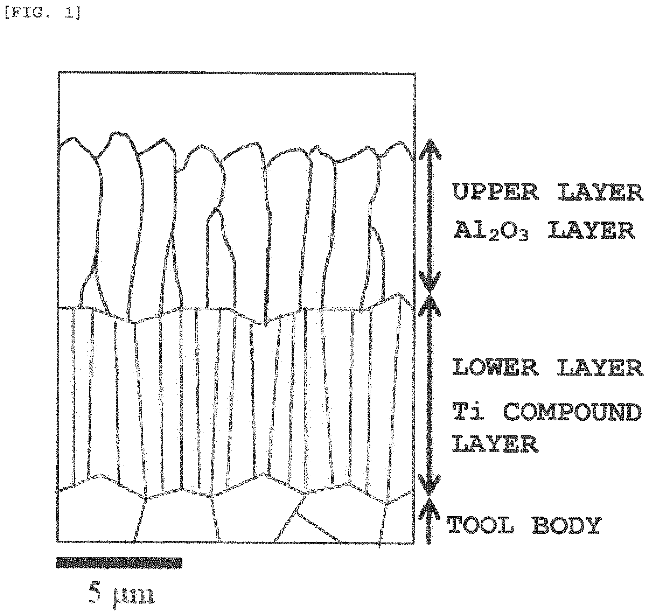

FIG. 1 is a schematic view of a cross-section in a direction vertical to a surface of a tool body regarding an invention coated tool.
FIG. 2 shows an example of a coincidence grain boundary distribution graph regarding an invention coated tool.
FIG. 3 shows an example of an inclined angle frequency distribution graph regarding the invention coated tool.

### Description of Embodiments

Embodiments of a coated tool of the invention will be described in detail based on examples.

### Examples

A WC powder, a TiC powder, a ZrC powder, a TaC powder, a NbC powder, a Cr₃C₂ powder, a TiN powder, and a Co powder having an average grain size of 1 to 3 µm were prepared as raw material powders, and these raw material powders were blended according to a blending composition shown in Table 1. Wax was further added and mixed therewith using a ball mill for 24 hours in acetone and dried under reduced pressure. Thereafter, the resulting material was press-formed into a green compact having a predetermined shape at a pressure of 98 MPa, and this green compact was vacuum-sintered by being kept at a predetermined temperature of 1370°C to 1470°C for 1 hour in a vacuum of 5 Pa. After sintering, tool bodies A to E made of a WC-based cemented carbide and having an insert shape defined in ISO-CNMG120408 were produced.

A TiCN powder (TiC/TiN=50/50 in terms of mass ratio), a ZrC powder, a TaC powder, a NbC powder, a Mo₂C powder, a WC powder, a Co powder, and a Ni powder having an average grain size of 0.5 to 2 µm were prepared as raw material powders. These raw material powders were blended according to a blending composition shown in Table 2, wet-mixed using a ball mill for 24 hours, and dried. Thereafter, the resulting material was press-formed into a green compact at a pressure of 98 MPa, and this green compact was sintered by being kept at a temperature of 1500°C for 1 hour under a nitrogen atmosphere of 1.3 kPa. After sintering, tool bodies a to e made of a TiCN-based cermet and having an insert shape defined in ISO-CNMG120412 were produced.

Next, each of the tool bodies A to E and a to e was put into a normal chemical vapor deposition device to produce invention coated tools 1 to 13 according to the following procedures.
(a) First, under conditions shown in Table 3, a Ti compound layer was deposited as a lower layer having a target layer thickness shown in Table 7.
(b) Next, under conditions shown in Table 4, an oxygen-containing TiCN layer (that is, 0.5 to 3 atom% (O/(Ti+C+N+O)x100) of oxygen was contained only in a depth region with a depth of up to 500 nm from a surface of the layer) was formed as an outermost surface layer of the lower layer so as to have a target layer thickness shown in Table 8. In the oxygen-containing TiCN layer type D of Table 4, a CO gas was not added during 5 to 30 minutes before termination of the vapor deposition time.
(c) Next, under conditions shown in Table 5, an oxidation treatment (lower layer surface treatment) was performed on the TiCN layer as the outermost surface of the lower layer using a mixture gas of CO and CO₂.
(d) Next, initial growth of Al₂O₃ was performed under initial growth conditions shown in Table 6, and deposition was performed under upper layer forming conditions shown in Table 6 until a target layer thickness shown in Table 8 was obtained.
(e) Next, a polishing treatment including a wet blast treatment was performed with 200 meshes of Al₂O₃ grains at a projection pressure of 0.12 MPa to produce the invention coated tools 1 to 13 shown in Table 8.

For comparison, the steps (b), (c), (d), and (e) were performed under conditions departing from the production conditions of the invention coated tools 1 to 13, and thus comparative example coated tools 1 to 13 shown in Table 9 were produced.

Next, regarding Al₂O₃ of the upper layer of the hard coating layer, angles of normal lines of crystal lattice planes of the Al₂O₃ crystal grains were measured using a field-emission-type scanning electron microscope and an electron beam backward scattering diffraction device, and from the results of the measurement, a crystal orientation relationship between the mutually adjacent crystal lattices was calculated to obtain a coincidence grain boundary distribution graph of Al₂O₃ of the upper layer.

Specifically, the coincidence grain boundary distribution graph was measured by the following method. In a state in which a cross-section of the Al₂O₃ layer as the upper layer of each of the invention coated tools 1 to 13 was treated to be a polished surface, the coated tool was set in a lens tube of a field-emission-type scanning electron microscope, and crystal grains having a corundum hexagonal crystal lattice present within a measurement range of the polished cross-section was individually irradiated with electron beams having an accelerating voltage of 15 kV at an incident angle of 70 degrees with respect to the polished cross-section and an illumination current of 1 nA. More specifically, in a region that was 50 µm wide in a direction parallel to the surface of the base body and whose upper limit was a layer thickness of the Al₂O₃ layer in a direction perpendicular to the direction of the surface of the base body, electron beams were irradiated at intervals of 0.1 µm/step using an electron beam backward scattering diffraction device, and orientations of normal lines of the planes of the crystal lattices constituting the crystal grains were measured at the respective measurement points irradiated with the electron beams. From results of the measurement, a crystal orientation relationship between the crystal lattices at the adjacent measurement points was calculated, From results of the calculation, among the mutually adjacent measurement points, it was regarded that a crystal grain boundary was present between measurement points between which the crystal orientation angle difference was 5 degrees or greater, a group of the measurement points surrounded by the crystal grain boundary was specified as one crystal grain, and the entire crystal grains were specified. With this, in a case where the crystal orientation relationship between the measurement points constituting a crystal lattice interface was within the range of an error Δθ=5° with respect to a value of the angle between the crystal grains constituting the coincidence grain boundary as described in the literatures such as the article of H. Grimmer, etc, it was regarded that a coincidence grain boundary was present between measurement points, and a ratio of ∑N+1 coincidence grain boundary relative to the whole grain boundary length was obtained. The measurement results are shown in Table 8 as a distribution ratio (%) of ∑3. As a method of calculating the distribution ratio of ∑31 or more, coincidence grain boundary lengths of ∑3, ∑7, ∑11, ∑17, ∑19, ∑21, ∑23, and ∑29 were calculated from the obtained measurement results, and a value obtained by subtracting the sum of the coincidence grain boundary lengths from the whole coincidence grain boundary length was used and obtained as a distribution ratio (%) of ∑31 or more.

The measurement results are shown in Table 8.

Next, regarding the Al₂O₃ layer as the upper layer of the comparative coated tools 1 to 13, a coincidence grain boundary distribution graph was obtained by the same method as in the cases of the invention coated tools 1 to 13.

The measurement results are shown in Table 9.

FIG. 2 shows an example of the coincidence grain boundary distribution graph obtained regarding the invention coated tool 1 obtained by the measurement.

Next, regarding the Al₂O₃ crystal grains constituting the upper layer of the invention coated tools 1 to 13, elemental map analysis was performed by an energy dispersive-type X-ray analysis method using high angle annular dark field scanning transmission electron microscopy (HAADF-STEM) in the measurement range of the polished cross-section in which the constituent atom sharing lattice point form had been measured, to perform the measurement regarding the segregation of sulfur in the Al₂O₃ crystal grain boundary. The measured elements were Al, O, Cl, and S.

The state in which sulfur is segregated in a grain boundary of the Al₂O₃ crystal grains is defined to be that when line analysis is performed on the elemental map data, a value obtained by subtracting the background value at the time of the measurement from the strength by the sulfur atoms on the grain boundary of the Al₂O₃ crystal grains is three or more times the average value of a value obtained by subtracting the background value at the time of the measurement from the strength by the sulfur atoms in the Al₂O₃ crystal grains. Among the grain boundary lengths of the Al₂O₃ crystal grains of the constituent atom sharing lattice point form of ∑31 or more, the grain boundary length in the constituent atom sharing lattice point form of ∑31 or more in which sulfur is segregated is calculated using a field-emission-type scanning electron microscope and an electron beam backward scattering diffraction device, and then divided by the whole grain boundary length in the constituent atom sharing lattice point form of ∑3 or more to obtain a ratio thereof.

The value thereof is shown in Table 8.

Next, regarding the Al₂O₃ layer as the upper layer of the comparative coated tools 1 to 13, a ratio of the grain boundary length in the constituent atom sharing lattice point form of ∑31 or more in which sulfur was segregated among the grain boundary lengths of the Al₂O₃ crystal grains in the constituent atom sharing lattice point form of ∑31 or more was obtained relative to the whole grain boundary length in the constituent atom sharing lattice point form of ∑3 or more in the same manner as in the same manner of the invention coated tools 1 to 13.

The value thereof is shown in Table 9.

In a case where the segregation of the sulfur in the grain boundary in the constituent atom sharing lattice point form of ∑31 or more is less than 20%, predetermined cracks are not formed, and thus the peeling resistance effect is reduced. In a case where the segregation of the sulfur is greater than 50%, the upper layer itself embrittles.

Next, regarding the TiCN layer constituting the outermost surface layer of the lower layer in the invention coated tools 1 to 13 and the comparative example coated tools 1 to 13, the average oxygen content (=O/ (Ti+C+N+O)x100) in a depth region with a depth of up to 500 nm in a layer thickness direction of the TiCN layer was obtained as follows: using an Auger electron spectral analyzer, a polished cross-section of the coated tool was irradiated with electron beams having a diameter of 10 nm in a distance range corresponding to the film thickness of the Ti carbide layer from the outermost surface of the Ti carbonitride layer of the lower layer to measure intensities of Auger peaks of Ti, C, N, and O, and a ratio of the Auger peak intensity of O was calculated from the sum of the peak intensities. With the above-described method, the maximum oxygen content (=O/(Ti+C+N+O)x100) in a depth region deeper than 500 nm was obtained to obtain a content of oxygen other than impurities. The maximum oxygen content is the maximum value of the oxygen content in the depth region deeper than 500 nm.

The values of the average oxygen content in the depth region with a depth of up to 500 nm and the maximum oxygen content in the depth region deeper than 500 nm are shown in Tables 8 and 9.

In addition, in order to obtain a content of the oxygen inevitably contained in the TiCN layer, chemical vapor deposition was performed under the following conditions on the surface of a tool body separately made of a tungsten carbide-based cemented carbide or a titanium carbonitride-based cermet.
Composition of Reaction Gas (vol%): 2% to 10% of TiCl₄, 0.5% to 1.0% of CH₃CN, 25% to 60% of N₂, H₂ as balance
Reaction Atmosphere Temperature: 780°C to 930°C
Reaction Atmosphere Pressure: 6 to 10 kPa

Accordingly, a TiCN (hereinafter, referred to as inevitable oxygen-containing TiCN) layer intentionally containing no oxygen was formed with a layer thickness of 3 µm or greater. The content of the oxygen contained inevitably in a region deeper than 100 nm in a layer thickness direction from a surface of the inevitable oxygen-containing TiCN layer was obtained from a ratio of the content of 0 to a total content of Ti, C, N, and O contained in the depth region using an Auger electron spectral analyzer, and the content of the inevitable oxygen obtained within an accuracy range of the Auger electron spectral analyzer was set to be less than 0.5 atom% .

In addition, regarding the Al₂O₃ layer as the upper layer of the invention coated tools 1 to 13 and the comparative coated tools 1 to 13, in a state in which the longitudinal section of the upper layer was treated to be a polished surface, the coated tool was set in a lens tube of a field-emission-type scanning electron microscope, and crystal grains having a corundum hexagonal crystal lattice present within a measurement range of the polished cross-section was individually irradiated with electron beams having an accelerating voltage of 15 kV at an incident angle of 70 degrees with respect to the polished cross-section and an illumination current of 1 nA. Within a measurement range having a length of 100 µm in a direction horizontal to the surface of the tool body and a distance that was equal to or less than the film thickness along the cross-section in a direction vertical to the surface of the tool body, inclined angles between normal lines of the (0001) planes that were crystal planes of the crystal grains and a normal line of the surface of the base body were measured at intervals of 0.01 µm/step using an electron beam backward scattering diffraction device. The measured inclined angles of 0 to 45 degrees among the measured inclined angles were divided every pitch of 0.25 degrees, and an inclined angle frequency distribution graph was made by totalizing the frequencies present within the respective divisions.

A maximum peak was present in an inclined angle division of 0 to 10 degrees, and a total of the frequencies present in the range of 0 to 10 degrees was obtained as a frequency ratio in the entire frequencies in the inclined angle frequency distribution graph.

The results thereof are shown in Tables 8 and 9.

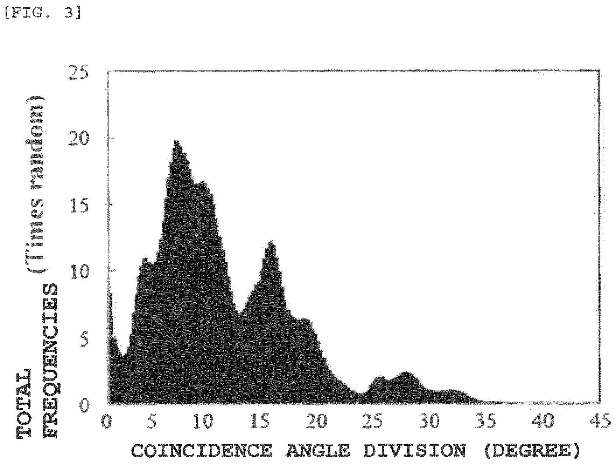

FIG. 3 shows an example of the inclined angle frequency distribution graph obtained regarding the invention coated tool 1 by the measurement.

Next, residual stresses of a flank face and a rake face including at least a cutting edge ridge line part of the invention coated tools 1 to 13 and the comparative coated tools 1 to 13 were measured through the following method.

A measurement sample was inserted into an X-ray analyzer and X-rays were made incident on a measurement surface (flank face or rake face) of the tool body using Cu (wavelength: 0.1541 nm) as an X-ray source. A (13-4,10) plane was selected as the crystal plane of Al₂O₃ to be measured and the stress was measured using a sin²φ method.

Tables 8 and 9 show the absolute values of the measured residual stress values.

Thicknesses of the constituent layers of the hard coating layer in the invention coated tools 1 to 13 and the comparative example coated tools 1 to 13 were measured (longitudinal section measurement) using a scanning electron microscope, and all of the layers had an average layer thickness (an average value obtained through the measurement at 5 points) that was substantially the same as a target layer thickness.

**[Table 1]**

| Type | | Blending Composition (mass%) | | | | | | | |
|---|---|---|---|---|---|---|---|---|---|
| | | Co | TiC | ZrC | TaC | NbC | Cr₃C₂ | TiN | WC |
| Tool body | A | 5.1 | - | 0.5 | - | 1.5 | - | 2.0 | Balance |
| | B | 5.5 | 1.5 | - | 0.5 | 1.0 | - | 1.0 | Balance |
| | C | 6.8 | - | 1.0 | - | - | 0.3 | 1.5 | Balance |
| | D | 7.8 | - | 1.5 | 1.0 | - | - | 1.0 | Balance |
| | E | 11.1 | 2.5 | - | 1.5 | - | - | | Balance |

**[Table 2]**

| Type | | Blending Composition (mass%) | | | | | | | |
|---|---|---|---|---|---|---|---|---|---|
| | | Co | Ni | ZrC | TaC | NbC | Mo₂C | WC | TiCN |
| Tool body | a | 8.5 | 7.5 | 0.5 | 6.5 | - | 5.0 | 13.0 | Balance |
| | b | 7.0 | 5.5 | 0.5 | 3.0 | 1.0 | 8.5 | 7.0 | Balance |
| | c | 11. 0 | 4.0 | - | 6.5 | 1.0 | 6.5 | 10.5 | Balance |
| | d | 11.6 | 4.5 | - | 5.0 | 0.5 | 6.5 | 11.5 | Balance |
| | e | 13.0 | 3.5 | 1.5 | - | 0.5 | 9.5 | 10.0 | Balance |

**[Table 3]**

| Lower Layer (Ti compound layer) | | Forming Conditions (The pressure of the reaction atmosphere is represented by KPa, and the temperature is represented by °C) | | |
|---|---|---|---|---|
| Type | Target Composition (The numerical values indicate atom ratios) | Composition of Reaction Gas (vol%) | Reaction Atmosphere | |
| | | | Pressure | Temperature |
| TiC Layer | TiC | TiCl₄: 4.2%, CH₄: 8.5%, H₂: balance | 7 | 1020 |
| TiN Layer (first layer) | TiN | TiCl₄: 4.2%, N₂: 30%, H₂: balance | 30 | 900 |
| TiN Layer (another layer) | TiN | TiCl₄: 4.2%, N₂: 35%, H₂: balance | 50 | 1040 |
| 1-TiCN Layer *1 | TiC_{0.5}N_{0.5} | TiCl₄: 4.2%, N₂: 20%, CH₃CN: 0.6%, H₂: balance | 7 | 880 |
| TiCN Layer | TiC_{0.5}N_{0.5} | TiCl₄: 4.2%, N₂: 20%, CH₄: 4%, H₂: balance | 12 | 1000 |
| TiCO Layer | TiC_{0.5}O_{0.5} | TiCl₄: 4.2%, CO: 4%, H₂: balance | 7 | 1020 |
| TiCNO Layer | TiC_{0.2}N_{0.3}O_{0.5} | TiCl₄: 4.2%, CO: 4%, CH₄: 3%, N₂: 20%, H₂: balance | 20 | 1020 |

| | | | | |
|---|---|---|---|---|
| *1) TiCN layer having a longitudinally grown crystal structure | | | | |

**[Table 4]**

| Type of Oxygen-Containing TiCN Layer | Forming Conditions (The pressure of the reaction atmosphere is represented by KPa, and the temperature is represented by °C) | | | CO Gas Added During 5 to 30 minutes Before Termination of vapor Deposition Time (vol%) |
|---|---|---|---|---|
| | Composition of Reaction Gas (vol%) | Reaction Atmosphere | | |
| | | Pressure | Temperature | |
| A | TiCl₄: 4%, CH₃CN: 0.8%, N₂: 40%, H₂: balance | 7 | 870 | 3 |
| B | TiCl₄: 2%, CH₃CN: 0.5%, N₂: 25%, H₂: balance | 5 | 930 | 1 |
| C | TiCl₄: 10%, CH₃CN: 1%, N₂: 60%, H₂: balance | 15 | 780 | 5 |
| D (out of range of claim 2) | TiCl₄: 25%, CH₃CN: 1.5%, N₂: 40%, H₂: balance | 10 | 830 | - |

**[Table 5]**

| Type of Surface Treatment for Lower Layer | Treatment Conditions (The pressure of the reaction atmosphere is represented by KPa, and the temperature is represented by °C) | | | |
|---|---|---|---|---|
| | Composition of Reaction Gas (vol%) | Reaction Atmosphere | | Treatment Time (min) |
| | | Pressure | Temperature | |
| A | CO: 4%, CO₂: 4%, H₂: balance | 10 | 900 | 30 |
| B | CO: 5%, CO₂: 5%, H₂: balance | 15 | 950 | 20 |
| C | CO: 3%, CO₂: 3%, H₂: balance | 5 | 850 | 60 |
| D (out of invention) | CO: 7%, CO₂: 7%, H₂: balance | 7 | 1000 | 30 |

**[Table 6]**

| Formation of Hard Coating Layer | | Forming Conditions (The pressure of the reaction atmosphere is represented by KPa, and the temperature is represented by °C) | | | |
|---|---|---|---|---|---|
| Step Type | Forming Symbol | Composition of Reaction Gas (vol%) | Reaction Atmosphere | | Treatment Time (min) |
| | | | Pressure | Temperature | |
| Initial Growth Conditions | A | AlCl₃: 2.0%, CO₂: 1.0%, HCl: 0.7%, H₂: balance | 7 | 900 | 30 |
| | B | AlCl₃: 1.5%, CO₂: 1.5%, HCl: 0.5%, H₂: balance | 15 | 950 | 20 |
| | C | AlCl₃: 3.0%, CO₂: 5.0%, HCl: 1.0%, H₂: balance | 5 | 850 | 90 |
| | D | AlCl₃: 0.5%, CO₂: 2.0%, HCl: 0.3%, H₂: balance | 10 | 920 | 60 |
| | E (out of invention) | AlCl₃: 2.5%, CO₂: 3.0%, HCl: 0.5%, H₂: balance | 8 | 1050 | 50 |
| Upper Layer Forming Conditions | a | AlCl₃: 2.0%, CO₂: 3.0%, HCl: 1.5%, H₂S: 0.8%, H₂: balance | 7 | 900 | (until target upper layer thickness is obtained) |
| | b | AlCl₃: 1.5%, CO₂: 2.0%, HCl: 0.5%, H₂S: 0.5%, H₂:balance | 15 | 950 | |
| | c | AlCl₃: 3.5%, CO₂: 10.0%, HCl: 2.0%, H₂S: 1.0%, H₂:balance | 5 | 850 | |
| | d | AlCl₃: 5.0%, CO₂: 7.0%, HCl: 1.3%, H₂S: 1.5%, H₂: balance | 10 | 920 | |
| | e (out of invention) | AlCl₃: 2.0%, CO₂: 6.0%, HCl: 1.5%, H₂S: 0.3%, H₂: balance | 8 | 1050 | |

**[Table 7]**

| Type | | Symbol of Tool body | Hard Coating Layer | | | |
|---|---|---|---|---|---|---|
| | | | Lower Layer (The numerical values of the lower lines represent a target average layer thickness (µm) of each layer) | | | |
| | | | First Layer | Second Layer | Third Layer | Fourth Layer |
| Invention Coated Tools/Comparative Example Coated Tools | 1 | A | TiN (0.5) | l-TiCN (7) | - | - |
| | 2 | a | TiC (1) | TiN (0.5) | TiCN (3) | l-TiCN (5) |
| | 3 | B | TiN (0.2) | l-TiCN (13) | TiN (0.3) | - |
| | 4 | b | TiC (0.5) | l-TiCN (8) | TiCNO (0.5) | - |
| | 5 | C | TiN (1) | TiCN (6) | TiN (0.5) | - |
| | 6 | c | TiN (0.5) | l-TiCN (4) | - | - |
| | 7 | d | TiN (1) | TiCN (3) | TiN (0.3) | TiCO (0.3) |
| | 8 | D | TiN (0.2) | l-TiCN (6) | - | - |
| | 9 | E | TiN (0.5) | TiCN (2) | - | - |
| | 10 | e | TiN (1) | l-TiCN (7) | - | - |
| | 11 | A | TiC (1) | TiN (0.5) | l-TiCN (18) | - |
| | 12 | D | TiN (0.3) | l-TiCN (4.5) | - | - |
| | 13 | b | TiC (0.5) | TiCN (2.5) | l-TiCN (12) | - |

**[Table 8]**

| Type | | Symbol of Tool body | Hard Coating Layer | | | | | | | | | | | |
|---|---|---|---|---|---|---|---|---|---|---|---|---|---|---|
| | | | Outermost Surface Layer of Lower Layer | | | | Type of Surface Treatment for Lower Layer (see Table 5) | Upper Layer | | | | | | |
| | | | Type of Oxygen-Containing TiCN Layer (see Table 4) | Average Oxygen Content in Depth Region with Depth of up to 500 nm in Layer Thickness Direction (atom%) | Maximum Oxygen Content in Depth Region Deeper Than 500 nm in Layer Thickness Direction (atom%) | Target Layer Thickness (µm) | | Initial Growth Conditions (see Table 6) | Upper Layer Forming Conditions (see Table 6) | Target Layer Thickness (µm) | Ratio of Grain Boundary Length of ∑31 in which S is Segregated Relative to whole Grain Boundary Length (%) | Ratio of Frequencies in 0 to 10 Degrees in Which Maximum Peak is Present in 0 to 10 Degrees (%) | Absolute value of Residual Stress of Flank Face (MPa) | Absolute Value of Residual Stress of Rake Face (MPa) |
| Invention coated Tools | 1 | A | A | 2.1 | 0.3 | 0.6 | A | A | a | 7.5 | 35 | 55 | 85 | 95 |
| | 2 | a | B | 1.2 | 0.2 | 0.5 | C | D | d | 12.0 | 46 | 60 | 130 | 170 |
| | 3 | B | C | 2.8 | 0.3 | 1.0 | B | B | b | 6.0 | 23 | 50 | 72 | 81 |
| | 4 | b | B | 1.5 | 0.3 | 0.7 | B | D | a | 15.0 | 27 | 62 | 175 | 189 |
| | 5 | C | C | 3.0 | 0.4 | 0.8 | A | C | c | 3.0 | 39 | 42 | 66 | 73 |
| | 6 | c | A | 1.9 | 0.3 | 1.1 | C | C | c | 5.0 | 33 | 46 | 80 | 88 |
| | 7 | d | A | 2.2 | 0.4 | 0.7 | C | B | d | 3.5 | 50 | 53 | 90 | 99 |
| | 8 | D | D | 0.6 | 0.1 | 0.8 | B | A | d | 2.0 | 42 | 38 | 113 | 120 |
| | 9 | E | B | 1.6 | 0.2 | 0.5 | A | B | b | 5.5 | 20 | 52 | 77 | 95 |
| | 10 | e | C | 2.6 | 0.4 | 0.7 | A | D | b | 4.0 | 26 | 55 | 90 | 84 |
| | 11 | A | C | 2.4 | 0.2 | 0.5 | C | A | b | 5.0 | 31 | 60 | 126 | 142 |
| | 12 | D | A | 2.0 | 0.3 | 0.9 | B | A | a | 7.0 | 37 | 63 | 140 | 155 |
| | 13 | b | B | 1.0 | 0.2 | 1.0 | A | A | d | 9.0 | 40 | 68 | 79 | 91 |

**[Table 9]**

| Type | | Symbol of Tool body | Hard Coating Layer | | | | | | | | | | | |
|---|---|---|---|---|---|---|---|---|---|---|---|---|---|---|
| | | | Outermost Surface Layer of Lower Layer | | | | Type of Surface Treatment for Lower Layer (see Table 5) | Upper Layer | | | | | | |
| | | | Type of Oxygen-Containing TiCN Layer (see Table 4) | Average Oxygen Content in Depth Region with Depth of up to 500 nm in Layer Thickness Direction (atom%) | Maximum Oxygen Content in Depth Region Deeper Than 500 nm in Layer Thickness Direction (atom%) | Target Layer Thickness (µm) | | Initial Growth Conditions (see Table 6) | Upper Layer Forming Conditions (see Table 6) | Target Layer Thickness (µm) | Ratio of Grain Boundary Length of ∑31 in Which S is Segregated Relative to whole Grain Boundary Length (%) | Ratio of Frequencies in 0 to 10 Degrees in Which Maximum Peak is Present in 0 to 10 Degrees (%) | Absolute Value of Residual Stress of Flank Face (MPa) | Absolute value of Residual Stress of Rake Face (MPa) |
| comparative Example Coated Tools | 1 | A | A | 2.1 | 0.3 | 0.6 | D | E | e | 7.5 | 5 | 35 | 242 | 261 |
| | 2 | a | B | 1.2 | 0.2 | 0.5 | C | D | e | 12.0 | 8 | 40 | 410 | 388 |
| | 3 | B | C | 2.8 | 0.3 | 1.0 | B | E | d | 6.0 | 60 | 66 | 126 | 150 |
| | 4 | b | B | 1.5 | 0.3 | 0.7 | D | C | c | 15.0 | 11 | 45 | 322 | 350 |
| | 5 | C | C | 3.0 | 0.4 | 0.8 | A | E | e | 3.0 | 5 | 25 | 199 | 215 |
| | 6 | c | A | 1.9 | 0.3 | 1.1 | C | C | e | 5.0 | 9 | 31 | 264 | 255 |
| | 7 | d | A | 2.2 | 0.4 | 0.7 | D | A | a | 3.5 | 18 | 29 | 148 | 170 |
| | 8 | D | D | 0.6 | 0.1 | 0.8 | D | D | b | 2.0 | 15 | 22 | 320 | 285 |
| | 9 | E | B | 1.6 | 0.2 | 0.5 | A | B | e | 5.5 | 3 | 29 | 222 | 256 |
| | 10 | e | C | 2.6 | 0.4 | 0.7 | A | E | b | 4.0 | 8 | 41 | 189 | 224 |
| | 11 | A | C | 2.4 | 0.2 | 0.5 | D | B | d | 5.0 | 55 | 59 | 301 | 335 |
| | 12 | D | A | 2.0 | 0.3 | 0.9 | B | E | e | 7.0 | 11 | 30 | 256 | 284 |
| | 13 | b | B | 1.0 | 0.2 | 1.0 | C | B | e | 9.0 | 8 | 32 | 278 | 210 |

Next, the various coated tools of the invention coated tools 1 to 13 and the comparative example coated tools 1 to 13 were subjected to a dry high-speed intermittent high feed rate cutting test (normal cutting speed, depth of cut, and feed rate: 200 m/min, 1.5 mm, and 0.3 mm/rev) of alloy steel under the following conditions (called cutting conditions A) in a state in which the coated tool was screw-fixed to a tip end portion of a turning tool made of tool steel by a fixing tool.
Work Material: 4 Longitudinal grooves were formed at regular intervals in a length direction of JIS·SCM440
Cutting Speed: 350 m/min
Depth of Cut: 1.5 mm
Feed Rate: 0.4 mm/rev
Cutting Time: 5 minutes

The coated tools were subjected to a dry high feed cutting test (normal cutting speed, depth of cut, and feed rate: 200 m/min, 1.5 mm, and 0.3 mm/rev) of nickel-chromium-molybdenum alloy steel under the following conditions (called cutting conditions B).
Work Material: Round bar of JIS·SNCM439
Cutting Speed: 100 m/min
Depth of Cut: 1.5 mm
Feed Rate: 1.1 mm/rev
Cutting Time: 5 minutes

The coated tools were subjected to a dry high-speed intermittent high feed and large depth of cutting test (normal cutting speed, depth of cut, and feed rate: 250 m/min, 1.5 mm, and 0.3 mm/rev) of cast iron under the following conditions (called cutting conditions C).
Work Material: Round bar of JIS·FC300 with 4 longitudinal grooves formed at regular intervals in a length direction
Cutting Speed: 450 m/min
Depth of Cut: 1.5 mm
Feed Rate: 0.4 mm/rev
Cutting Time: 5 minutes

In any cutting test, a width of wear of the flank face of a cutting edge was measured.

The results of the measurements are shown in Table 10.

**[Table 10]**

| Type | | Flank Wear Width (mm) | | | Type | | Cutting Test Results (min) | | |
|---|---|---|---|---|---|---|---|---|---|
| | | Cutting Conditions (A) | Cutting Conditions (B) | Cutting Conditions (C) | | | Cutting Conditions (A) | Cutting Conditions (B) | Cutting Conditions (C) |
| Invention Coated Tools | 1 | 0.13 | 0.14 | 0.18 | Comparative Example Coated Tools | 1 | **1.5 | *0.7 | **1.4 |
| | 2 | 0.17 | 0.15 | 0.21 | | 2 | **1.8 | *1.0 | **1.9 |
| | 3 | 0.24 | 0.22 | 0.26 | | 3 | *0.9 | *2.5 | *1.0 |
| | 4 | 0.18 | 0.15 | 0.21 | | 4 | **1.9 | *0.9 | **2.0 |
| | 5 | 0.25 | 0.18 | 0.25 | | 5 | *1.2 | *0.6 | **1.7 |
| | 6 | 0.21 | 0.17 | 0.28 | | 6 | **1.5 | *1.1 | **1.2 |
| | 7 | 0.18 | 0.20 | 0.23 | | 7 | **1.7 | *1.3 | **1.8 |
| | 8 | 0.28 | 0.30 | 0.27 | | 8 | **0.6 | *0.4 | **0.8 |
| | 9 | 0.22 | 0.25 | 0.29 | | 9 | *0.9 | *1.4 | *1.3 |
| | 10 | 0.17 | 0.18 | 0.19 | | 10 | *1.6 | *1.2 | **1.1 |
| | 11 | 0.15 | 0.13 | 0.16 | | 11 | *1.1 | *2.3 | *0.9 |
| | 12 | 0.17 | 0.20 | 0.23 | | 12 | **1.3 | *1.7 | **1.5 |
| | 13 | 0.15 | 0.16 | 0.20 | | 13 | *1.8 | *1.4 | **2.0 |

| | | | | | | | | | |
|---|---|---|---|---|---|---|---|---|---|
| (In the table, the symbol * represents the occurrence of peeling of the hard coating layer, and the symbol ** represents a cutting time until the service life is reached due to the occurrence of chipping of the hard coating layer.) | | | | | | | | | |

From the results shown in Table 10, in the invention coated tools 1 to 13, the upper layer thereof had excellent peeling resistance and chipping resistance, and thus the coated tools exhibited excellent cutting performance over a long period of use.

On the other hand, in the comparative example coated tools 1 to 13, the service life was reached for a relatively short period of time due to the occurrence of peeling and/or chipping of the hard coating layer in high-speed heavy cutting or high-speed intermittent cutting.

### Industrial Applicability

As described above, a coated tool according to the invention exhibits excellent cutting performance over a long period of use with no generation of peeling and/or chipping of a hard coating layer in continuous cutting or intermittent cutting of various steels, cast irons, and the like under normal conditions, and even under severe cutting conditions such as heavy cutting conditions with high-speed, large depth of cut and high feed rate in which a high load is exerted on a cutting edge. Therefore, it is possible for the coated tool according to the invention to sufficiently satisfactorily cope with power saving, energy saving, and cost reduction in cutting in addition to an improvement in performance of the cutting device.

## Claims

1. A surface-coated cutting tool comprising:
a tool body that is made of a tungsten carbide-based cemented carbide or a titanium carbonitride-based cermet; and
a hard coating layer that includes a lower layer and an upper layer and is formed on a surface of the tool body,
wherein (a) the lower layer has a total average layer thickness of 3 to 20 µm and includes two or more of a TiC layer, a TiN layer, a TiCN layer, a TiCO layer, and a TiCNO layer, and at least one of the layers is a Ti compound layer including a TiCN layer,
(b) the upper layer has an average layer thickness of 2 to 15 µm and includes an Al₂O₃ layer having an α-type crystal structure, and
(c) regarding Al₂O₃ crystal grains of the upper layer, in a case where a polished cross-section is subjected to observation and elemental analysis using high angle annular dark field scanning transmission electron microscopy and observation using a field-emission-type scanning electron microscope and an electron beam backward scattering diffraction device, angles between each of normal lines of crystal lattice planes formed of corundum hexagonal crystal lattices and a normal line of the polished cross-section are measured, and from results of the measurement, a crystal orientation relationship between the mutually adjacent crystal lattices is calculated and the distribution of lattice points (constituent atom sharing lattice points) where respective constituent atoms constituting a crystal lattice interface share one constituent atom between the crystal lattices is calculated; in a case where a constituent atom sharing lattice point form in which N lattice points that do not share any constituent atoms between the constituent atom sharing lattice points are present is expressed by ∑N+1, distribution ratios of individuals of ∑N+1 are calculated; and in a coincidence grain boundary distribution graph showing ratios of respective coincidence grain boundary lengths formed of the constituent atom sharing lattice points in the whole coincidence grain boundary length, sulfur is segregated in a grain boundary in the constituent atom sharing lattice point form of ∑31 or more, and a grain boundary length thereof is 20% to 50% relative to the whole grain boundary length in the constituent atom sharing lattice point form of ∑3 or more.

2. The surface-coated cutting tool according to claim 1,
wherein the outermost surface layer of the lower layer (a) includes a TiCN layer having a layer thickness of at least 500 nm or more and contains oxygen only in a depth region with a depth of up to 500 nm from an interface between the TiCN layer and the upper layer, except for oxygen as inevitable impurities, and an average content of the oxygen contained in the depth region is 1 to 3 atom% of a total content of Ti, C, N, and O contained in the depth region.

3. The surface-coated cutting tool according to claim 1 or 2,
wherein regarding the Al₂O₃ crystal grains of the upper layer, in a case where, using a field-emission-type scanning electron microscope and an electron beam backward scattering diffraction device, crystal grains having a corundum hexagonal crystal lattice that are present within a measurement range of a polished cross-section are individually irradiated with electron beams to measure inclined angles between normal lines of (0001) planes that are crystal planes of the crystal grains and a normal line of the surface of the tool body, and the measured inclined angles of 0 to 45 degrees among the measured inclined angles are divided every pitch of 0.25 degrees and expressed by an inclined angle frequency distribution made by totalizing the frequencies present within the respective divisions, a maximum peak is present in an inclined angle division of 0 to 10 degrees, and a total of frequencies present in the range of 0 to 10 degrees is 50% or greater of the entire frequencies in an inclined angle frequency distribution graph.

4. The surface-coated cutting tool according to any one of claims 1 to 3,
wherein absolute values of residual stresses of a flank face and a rake face of the surface-coated cutting tool are 100 MPa or less.
